# EUROPEAN PATENT APPLICATION

(11) **EP 4 723 815 A1**
(43) Date of publication of application: **08.04.2026**
(21) Application number: 24204626.6
(22) Date of filing: 04.10.2024
(51) Int. Cl.: H05K 5/06, H05K 7/20

(54) **IMMERSION COOLING SYSTEM AND METHOD**

(71) Applicant: Vertiv International GmbH, 8200 Schaffhausen (CH)
(72) Inventor: Ebermann, Heiko, 01109 Dresden (DE)
(74) Representative: Wunderlich & Heim Patentanwälte PartG mbB

(57) **Abstract**

Immersion cooling system and immersion cooling method, in particular with phase change of the cooling medium. The Immersion cooling system comprising a cooling tank (3) for receiving an object to be cooled (1) and a cooling medium, preferably deionized water, a vacuum pump (6) for reducing a pressure level inside the cooling tank (3) to partial vacuum in order to reduce the boiling point of the deionized water, and a condenser (2) for condensing the cooling medium circulated from the cooling tank (3).

## Description

The present invention concerns an immersion cooling system and an immersion cooling method, in particular with phase change of the cooling medium.

Immersion cooling, also termed "liquid submersion cooling," is a method of submerging electronic equipment like IT hardware in the form of computer components or full servers in a thermally, but not electrically, conductive cooling medium or coolant, normally in the form of a liquid. This way of cooling electronic equipment does not require fans and the heat exchange between the warm coolant and a cool water circuit usually occurs through a condenser in the form of a heat exchanger, e.g., a heater core or radiator.

In immersion cooling, the heat is transferred directly away from the heat source using the cooling medium or coolant. With immersion cooling, the cooling medium or coolant must be non-conductive fluids, such as de-ionized water, mineral oil, fluorocarbon-based fluids, synthetic fluids.

The continuing increase in the heat flux density of integrated circuits such as the central processing unit (CPU) and the graphics processing unit (GPU) in servers means that previous methods of heat dissipation, such as air cooling, but also immersion cooling or cooling with heat sinks without phase change, are reaching their limits. With high-performance CPUs and GPUs in particular, it is necessary to utilize the very high specific surface cooling capacity that results from cooling with phase change.

Among the various cooling methods, immersion cooling has proven to be advantageous, as almost 100% of the heat load can be absorbed by the fluid used for immersion cooling. In contrast, when cooling with liquid-cooled chillers, around 20% to 30% of the heat load remains in the cooling air.

The immersion cooling solutions with phase change cooling currently on the market all use fluids that contain per- and polyfluoroalkyl substances (PFAS). Their degradation products are extremely long-lasting and known as perpetual chemicals. Their negative impact on biological organisms has led to a widespread ban on or at least costly security measures and legal regulations in connection with the use of these substances.

Water itself is a non-conductive liquid, but in its natural form it is enriched with ions, so that it is not suitable as a non-conductive fluid for immersion cooling in this form. However, processes have been introduced that deionize water and thus recreate its original non-conductive properties. This makes water suitable as a fluid for immersion cooling in terms of electrical conductivity. Moreover, water is environmentally friendly and its use is sustainable, as it may be operated in a closed cooling circuit and is therefore not consumed.

As in many sectors of refrigeration technology, preference should thus be given to the use of natural refrigerants in immersion cooling with phase change. The subject of the invention is the use of water as a natural refrigerant, also known as R718. However, water has two decisive disadvantages: the boiling temperature at atmospheric air pressure at sea level is 100°C and is therefore clearly too warm for IT cooling in which the usual temperatures for the cooling process for immersion cooling are between 30°C and 50°C. Another disadvantage is that water, as it occurs in nature, is electrically conductive. However, immersion cooling only works with non-conductive liquids.

It is the object of the invention to provide an immersion cooling system and an immersion cooling method, in particular, with with phase change of the cooling medium that is environmentally friendly and effective.

The invention provides an immersion cooling system with the features of claim 1 and an immersion cooling method with the features of claim 11. Further embodiments are defined in the dependent claims.

An aspect of the invention in particular provides an immersion cooling system comprising a cooling tank for receiving an object to be cooled and a cooling medium, a vacuum pump for reducing a pressure level inside the cooling tank to partial vacuum, and a condenser for condensing the cooling medium circulated from the cooling tank.

Another aspect of the invention also in particular provides an immersion cooling method with phase change (2-phase immersion cooling), comprising reducing a pressure level inside a closed cooling tank holding an object to be cooled and a cooling medium in an open liquid bath to partial vacuum, and circulating the gaseous cooling medium from the cooling tank to a condenser where the cooling medium is condensed.

The usual temperatures for the cooling process for immersion cooling are between 30°C and 50°C, in any case well below the boiling temperature of water at atmospheric air pressure at sea level. In order to set a boiling temperature suitable for liquid cooling with phase change, the invention teaches to lower the pressure in the tank to below the atmospheric pressure (i.e. to partial vacuum) so that the water boils at the desired temperature. For this purpose, the tank is equipped with a vacuum pump that sets the desired pressure. It must also be ensured that the condenser or heat exchanger for condensing the evaporated water is designed in such a way that sufficient cooling capacity is available and the pressure in the tank does not exceed the set pressure, which corresponds to the boiling point.

If the pressure in the tank nevertheless rises, the boiling point also increases, which is accompanied by a reduced cooling capacity of the electronic equipment (for example IT equipment) in the cooling tank. The cooling capacity of the condenser, which then increases, can rebalance the cooling process and lower the pressure to the target level. Furthermore, the vacuum pump ensures that the necessary partial vacuum is maintained in the tank.

The cooling medium may be a fluid that is free from per- and polyfluoroalkyl substances, alternatively is deionized water, also known as R718 especially ultrapure water ASTM D 1193-06 Type I / ISO 3696:1987 Grade 1.

The invention thus combines the advantages of 2-phase immersion cooling with environmentally friendly and sustainable coolant water. Water as a cooling medium or coolant is environmentally friendly, has no global warming potential, and has no negative effects on biological organisms. 2-phase immersion cooling increases the cooling capacity significantly compared to the cooling capacity of single-phase immersion cooling solutions. Lastly, water as the cooling medium or coolant is not flammable.

Preferably, the vacuum pump is configured to reduce the pressure level inside the cooling tank such that the boiling point of the deionized water is adjusted to be from 40 to 60°C, preferably from 40 to 50°C, preferably to a pressure level that corresponds to an ambient pressure of approx. 10kPa or less. The exact boiling temperature can be well controlled with the pressure. The vacuum pump is used to bring the pressure down to this low level. This pressure is in the upper range of a low vacuum.

The immersion cooling system may comprise circulating means, like a fan, for actively circulating the gaseous cooling medium to the condenser or heat exchanger. The condenser may be part of an external cooling device and may communicate with the cooling tank through closed circuitry. The provision of the circulating pump and the closed circuitry enhances the transport of the gaseous evaporated cooling medium to the condenser in a closed loop.

Preferably, the cooling tank includes an open liquid bath with an open liquid-air interface for receiving a body of the cooling medium in liquid form up to a liquid filling level. In such open liquid bath the condenser may be an integral part of the cooling tank that is arranged such that the condensed cooling medium freely returns to the open liquid bath of the cooling tank after condensation, i.e. forms an open circuit.

In order to adapt the immersion cooling system suitable for IT cooling the cooling tank may be configured to accommodate electronic equipment, preferably in the form of IT hardware like computer components or full servers and bring the electronic equipment in direct or indirect contact with the cooling medium.

In order to facilitate access to the electronic equipment in the tank the cooling tank may comprise a lid that is configured to sealingly open and close, in a pressure tight manner, an access opening for introducing the electronic equipment, preferably the IT equipment.

In order to provide for continuous operation of the electronic equipment inside the tank the cooling tank may comprise a sealed power and data supply interface for transmitting power/data between an outside of the cooling tank and the electronic equipment inside the cooling tank.

Preferably, the immersion cooling system comprises means for measuring the electrical resistivity/electrical conductivity of the deionized water in the tank and means for extracting and deionizing the water if the measured electrical resistivity is above a predefined threshold. Water in its original and pure form is a non-conductive liquid. In its natural form, however, it is enriched with ions that cause the conductivity of the water. If these ions are removed from the water, the water is suitable for immersion cooling. In industry, for example in paint shops, processes are known that deionize water. These processes can also be used in water treatment for immersion cooling. As the operation of the IT equipment cannot rule out the possibility of ions entering the water again, the conductivity of the water must be measured continuously. If necessary, the water can be deionized periodically or permanently.

The invention is now described by reference to the attached drawing in which:

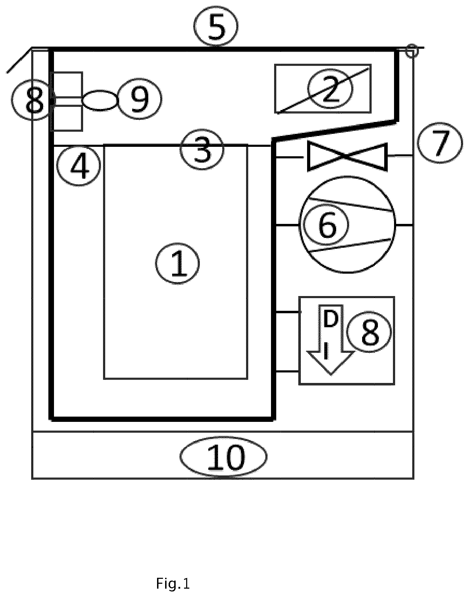

Fig. 1 is a schematic concept diagram of an immersion cooling system according to an embodiment of the invention.

The immersion cooling system of Fig. 1 comprises a sealed cooling or vacuum tank 3 for receiving an object to be cooled 1 and a liquid cooling medium or coolant in which the object is partially or completely received.

The cooling medium or coolant (the terms are synonymously used in this disclosure) preferably is a fluid that is free from per- and polyfluoroalkyl substances (PFAS). Preferably, the cooling medium or coolant is used in connection with the present invention is deionized water, also referred to as R718.

The cooling tank 3 is in particular configured to accommodate electronic equipment (for example IT equipment like a computer or server) as the object to be cooled and bring the electronic equipment 1 in direct contact (i.e. in that the object is submerged in the cooling medium) or indirect contact (i.e. in that the object is shielded from direct contact) with the cooling medium. The cooling tank 3 is sufficiently rigid to withstand the atmospheric pressure acting on the outside.

The immersion cooling system further comprises a vacuum pump 6 communicating with the cooling tank 3 for reducing a pressure level inside the cooling tank 3 to a partial vacuum. The vacuum pump 6 is configured to reduce the pressure level inside the cooling tank 3 such that the boiling point of the deionized water is adjusted to be considerably lower than 100° at atmospheric pressure, preferably from 40 to 60°C, preferably from 40 to 50°C, preferably to a pressure level that corresponds to an ambient pressure of approx. 1 0kPa or less. Depending on the case the boiling point of the water may be adjusted to a value that is above 60°C.

The immersion cooling system further comprises a condenser 2 for condensing the evaporated gaseous cooling medium circulated from the cooling tank 3. In the schematic diagram the cooling tank 3 includes an open liquid bath with an open liquid-air interface 4 for receiving a body of the cooling medium in liquid form. The condenser 2 in the form of a heat exchanger is an integral part of the cooling tank 3 and is arranged inside an upper free space of the tank such that the condensed liquid cooling medium freely returns to the open liquid bath of the cooling tank 3. The condensed cooling medium may, for example, drip down from the condenser and flow along an inclined surface or channel towards the body of the cooling medium.

In an alternative arrangement (not shown) the condenser 2 may be part of an external cooling device and may communicate with the cooling tank 3 through a closed circuitry. In order to convey or circulate the evaporated gaseous cooling medium to the condenser, circulating means like a fan may be provided.

The condenser 2 typically has a heat exchanger section to cool down and condense incoming vapor into liquid. In this heat exchanger section, the coolant vapor may pass through multiple tube passes, which are surrounded by heat transfer fins through which a secondary cooling or condensing medium like air or a liquid like water can circulate from outside to inside. In such a surface, condenser 2 the condensing medium and vapor are physically separated if direct contact is not desired. A typical form of a surface condenser used in air conditioning and cooling systems is a shell and tube heat exchanger in which the secondary cooling or condensing medium flows through a tube side and the vapors enter a shell side where the condensation occurs on the outside of the heat transfer tubes. The condensate drips down and collects at the bottom, often in a built-in pan. The shell side may operate at a partial vacuum, produced by the difference in specific volume between the vapor and the condensate. Conversely, the vapor can be fed through the tubes with the secondary coolant (water or air) flowing around the outside. A fan or pump may be provided to circulate the secondary cooling medium. Various types and configurations of condensers may be used in order to provide the effect of condensing the water vapor.

The cooling tank 3 comprises a lid 5 that is configured to sealingly open and close an access opening for introducing the electronic equipment 1, preferably IT equipment into the cooling tank 3 and for providing access for maintenance purposes. The connection between the lid 5 and the tank 3 may be in the form of any suitable mechanical releasable locking structure that is designed to withstand the atmospheric pressure acting on it from the outside while the inside is at the partial vacuum.

The cooling tank 3 also comprises a sealed power and data supply interface in the form of a power distribution units 8 and a vacuum-tight cable entry or other type of data interface 9 for transmitting power/data between an outside of the cooling tank 3 and the electronic equipment 1 inside the closed and sealed cooling tank 3. Even a contact-less data transmission between the inside and the outside of the cooling tank 3 may be envisaged.

There may be provided a relief valve 7 that communicates with the inside of the cooling tank 3 in order to allow the partial vacuum inside the tank to be selectively released which is, for example, required to open the lid 5. The relief valve may be a separate component or may be integrated with the vacuum pump.

The immersion cooling system may further comprise means (not shown) for measuring the electrical resistivity/electrical conductivity of the deionized water and means for extracting and deionizing the water if the measured electrical resistivity is above a predefined threshold. The detection of an increase in electrical resistivity/electrical conductivity may also trigger a visual and/or audible alarm or warning. The conductivity of the water can be measured continuously or in intervals. If necessary, the extracted water can be deionized periodically or permanently as is known per se in the art, for example in the field of paint shops or laboratory water purification treatment.

## Claims

1. Immersion cooling system comprising:
a cooling tank (3) for receiving an object to be cooled (1) and a cooling medium;
a vacuum pump (6) for reducing a pressure level inside the cooling tank (3) to partial vacuum; and
a condenser (2) for condensing the cooling medium circulated from the cooling tank (3).

2. Immersion cooling system according to claim 1 wherein
the cooling tank (3) includes an open liquid bath for receiving a body of the cooling medium in liquid form.

3. Immersion cooling system according to claim 2, wherein
the condenser (2) is an integral part of the cooling tank (3) and is arranged such that the condensed cooling medium freely returns to the open liquid bath of the cooling tank (3).

4. Immersion cooling system according to any one of claims 1 to 3, wherein
the cooling tank (3) is configured to accommodate electronic equipment (1) and bring the electronic equipment (1) in direct or indirect contact with the cooling medium.

5. Immersion cooling system according to claim 4, wherein
the cooling tank (3) comprises a lid (5) that is configured to sealingly open and close an access opening for introducing the electronic equipment (1), preferably IT equipment, and/or a sealed power and data supply interface (8,9) for transmitting power/data between an outside of the cooling tank (3) and the electronic equipment (1) inside the cooling tank (3).

6. Immersion cooling system according to any one of claims 1 to 5, wherein
the cooling medium a fluid that is free from per- and polyfluoroalkyl substances, preferably is deionized.

7. Immersion cooling system according to claim 6, comprising
means for measuring the electrical resistivity/electrical conductivity of the deionized water and means for extracting and deionizing the water if the measured electrical resistivity is above a predefined threshold.

8. Immersion cooling system according to claim 6 or 7, wherein
the vacuum pump (6) is configured to reduce the pressure level inside the cooling tank (3) such that the boiling point of the deionized water is adjusted to be from 40 to 60°C, preferably from 40 to 50°C, preferably to a pressure level that corresponds to an ambient pressure of approx. 10kPa or less.

9. Immersion cooling system according to any one of claims 1 to 8, comprising:
circulating means for circulating the gaseous cooling medium to the condenser (2).

10. Immersion cooling system according to any one of claims 1 to 9, wherein
the condenser (2) is part of an external cooling device and communicates with the cooling tank (3) through circuitry.

11. Immersion cooling method, preferably with phase change, comprising:
reducing a pressure level inside a closed cooling tank holding an object to be cooled and a cooling medium in an open liquid bath to partial vacuum; and
circulating the gaseous cooling medium from the cooling tank to a condenser where the cooling medium is condensed.

12. Immersion cooling method according to claim 11, comprising
returning the condensed cooling medium to the open liquid bath in the cooling tank.

13. Immersion cooling method according to claim 11 or 12, comprising
measuring the electrical resistivity/electrical conductivity of the water and deionizing the water if the measured electrical resistivity is above a predefined threshold.

14. Immersion cooling method according to claim 11, 12, or 13, wherein
the cooling medium a fluid that is free from per- and polyfluoroalkyl substances, preferably is deionized water.

15. Immersion cooling system according to any claim 14, wherein
the pressure level inside the cooling tank (3) is reduced such that the boiling point of the deionized water is adjusted to be from 40 to 60°C, preferably from 40 to 50°C, preferably to a pressure level that corresponds to an ambient pressure of approx. 10kPa or less.
